# EUROPEAN PATENT APPLICATION

(11) **EP 1 798 598 A1**
(43) Date of publication of application: **20.06.2007**
(21) Application number: 05805256.4
(22) Date of filing: 25.10.2005
(51) Int. Cl.: G03F 7/075, G03F 7/039

(54) **POSITIVE PHOTOSENSITIVE COMPOSITION**

(30) Priority: 30.11.2004 JP 2004346790
(71) Applicant: THINK LABORATORY CO., LTD., Chiba-ken, 227-0861 (JP)
(72) Inventor: SATO, Tsutomu, ashiwa-shi, Chiba;2778525 (JP)
(74) Representative: Grünecker, Kinkeldey, Stockmair & Schwanhäusser Anwaltssozietät
(86) International application number: PCT/JP2005/019540
(87) International publication number: WO 2006/059435

(57) **Abstract**

Provided is a positive photosensitive composition excellent in an etching factor and adhesion. The composition includes: (A) an alkali-soluble high molecular substance having in the molecule thereof at least one carboxyl group, (B) a photo-thermal conversion material which absorbs infrared rays from an image exposure light source to convert the rays to heat, and (C) a silane coupling agent. The silane coupling agent (C) is preferably a silane coupling agent having an alkoxysilyl group and at least one functional group selected from the group consisting of imidazole, vinyl, epoxy, methacryloxy, acryloxy, amino, mercapto, isocyanate, styryl, and polysulfide groups.

## Description

### Technical Field:

The present invention relates to a positive photosensitive composition, more specifically, an alkali-soluble positive photosensitive composition which has such an infrared wavelength range laser sensitivity that the composition is exposed to a laser ray having a wavelength of 700 to 1,100 nm so as to be sensitized and then the sensitized portion becomes soluble in an alkaline developing solution. The positive photosensitive composition of the present invention can be used effectively for photo-fabrication, and can be in particular preferably used in the field of photo-fabrication which is applied to the production of a printing plate, an electric member, a precision instrument member, a member related to forgery prevention, or the like.

### Background Art:

In recent years, there have been proposed positive photosensitive compositions which have such a near infrared wavelength range laser sensitivity that the compositions are exposed to a near infrared wavelength range laser so as to be sensitized and then the sensitized portion becomes soluble in a developing solution (see, for example, Patent Documents 1 and 2, and so on). However, these positive photosensitive compositions have a problem that when materials coated with the compositions are subjected to etching, the materials are not only etched in the depth direction but also etched beneath the coated film and in the horizontal direction (this is called side etching). For high precision processing, it is desired to improve the etching factor. The etch factor is an index representing the amount of the side etching, and is a value obtained by dividing the etching depth by the etching width in the horizontal direction (see Non-Patent Document 1 and so on).
Patent Document 1: JP-A No.11-174681
Patent Document 2: JP-A No. 11-231515
Patent Document 3: JP-A No. 2003-337408
Patent Document 4: JP-B No. 47-25470
Patent Document 5: JP-B No. 48-85679
Patent Document 6: JP-B No. 51-21572
Patent Document 7: JP-B No. 7-68256
Non-Patent Document 1: "Photo-etching and Minute Processing", written by Kiyotake Naraoka and Kohji Nihei and published by Sogo Denshi Publishing Co., Ltd., 1977

### Disclosure of the Invention:

### Problems to be Solved by the Invention:

An object of the present invention is to provide a positive photosensitive composition which is excellent in an etching factor and adhesion.

### Means for Solving the Problems:

In order to solve the above-mentioned problems, the positive photosensitive composition of the present invention is a positive photosensitive composition having a good etch factor and including: (A) an alkali-soluble high molecular substance having in the molecule thereof at least one carboxyl group, (B) a photo-thermal conversion material which absorbs infrared rays from an image exposure light source to convert the rays to heat, and (C) a silane coupling agent.

The silane coupling agent (C) is preferably a silane coupling agent having an alkoxysilyl group and at least one functional group selected from the group consisting of imidazole, vinyl, epoxy, methacryloxy, acryloxy, amino, mercapto, isocyanate, styryl, and polysulfide groups.

The high molecular substance (A) is preferably at least one polymer selected from the group consisting of a polymer obtained from an unsaturated compound (a1) having at least one carboxyl group and/or at least one carboxylic acid anhydride group and a copolymer obtained from the unsaturated compound (a1) and a compound (a2) copolymerizable with the unsaturated compound.

The unsaturated compound (a1) is preferably at least one compound selected from the group consisting of maleic acid, (meth)acrylic acid and their derivatives. In the present invention, acryl and methacryl are collectively called (meth)acryl.

The high molecular substance (A) is preferably at least one polymer selected from the group consisting of a maleic acid polymer, a (meth)acrylic acid polymer, a styrene/maleic acid copolymer and their derivatives.

The high molecular substance (A) is preferably a reactant of a high molecular substance having a carboxylic acid anhydride group and a compound having a hydroxyl group, and is more preferably a styrene/maleic acid copolymer obtained by reacting a styrene/maleic anhydride copolymer with a compound having a hydroxyl group. The compound having a hydroxyl group is preferably an alcohol.

The high molecular substance (A) is preferably a polymer represented by the following general formula (1):

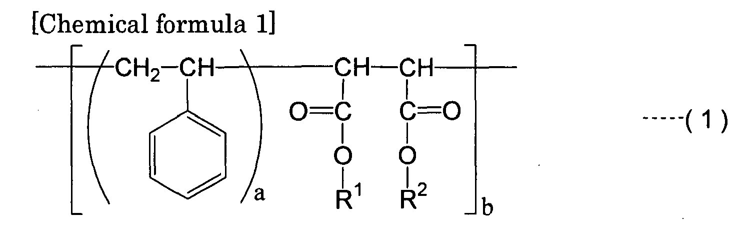

In the formula (1), "R¹" and R²" each independently represent a hydrogen atom or a substituted or unsubstituted alkyl group, plural "R¹" and "R²" may be the same or different provided that at least one of the plural "R¹" and "R²" is a hydrogen atom, "a" is an integer of 1 to 3, and "b" is an integer of 6 to 8.

Preferably, the positive photosensitive composition of the present invention further comprises (D) a dissolution inhibitor. The dissolution inhibitor (D) is preferably a compound represented by the following chemical formula (2):

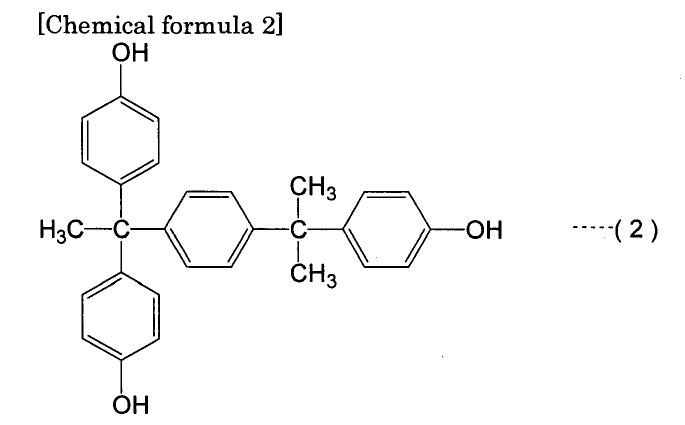

A photo-fabrication method of the present invention comprises the use of the positive photosensitive composition of the present invention. The photo- fabrication method is preferably applied to production of a printing plate, an electronic component, a precision equipment component or a component relating to a counterfeit deterrence.

A plate-making method of the present invention comprises the use of the positive photosensitive composition of the present invention. Printing plates such as an intaglio (gravure), lithography, relief and mimeograph may be produced by the plate-making method of the present invention.

A general plate-making process of a gravure plate using the positive photosensitive composition of the present invention as a sensitizing solution is as follows.
1. Application of a sensitizing solution to a cylinder (dry film thickness: preferably 2 to 5 µm, the film is preferably thicker to reduce pinholes, but the film is preferably thinner because the amount of the solution to be used is reduced and the production cost is reduced that much) → 2. Drying (until touch dry: 15 minutes → until end: 15 to 20 minutes) → 3. Exposure (light source: semiconductor laser 830 nm, 220 mJ/cm²) → 4. Development (60 to 90 seconds/25°C) → 5. Washing with water (spray, 30 seconds) → 6. Etching (depth: 10 to 30 µm, etching: a solution of cupric chloride in water, conversion of copper: 60 g/L) → 7. Peeling of resist (peeling using an alkali) → 8. Washing with water → 9. Cr plating (chromic acid: 250 g/L, sulfuric acid: 2.5 g/L in water) → 10. Washing with water → 11. Printing.

A general plate-making process of a lithography (PS plate) using the positive photosensitive composition of the present invention as a sensitizing solution is as follows.
1. CTP (PS plate) (aluminum abrasion → application of a sensitizing solution → drying) → 2. Exposure (light source: semiconductor laser 830 nm, 220 mJ/cm²) → 3. Development → 4. Printing.

### Effects of the Invention:

According to the positive photosensitive composition of the present invention, the following very great effects are produced: satisfactory development is attained; the adhesion after exposure is good; a good etching factor is attained; and the side etching amount is restrainable even if the etching depth is large. In the positive photosensitive composition of the present invention, a high molecular substance having a carboxyl group is used and thus development can be carried even if the alkaline strength of a developing solution is low; therefore, a drop of the alkaline developing solution with the passage of time is small, and thus the composition is easily controlled as to a reduction in alkaline concentration and waste treatment is easy. Furthermore, the composition can be very satisfactorily developed without burning at high temperature which is required for conventional positive photosensitive compositions.

### Best Mode for Carrying out the Invention:

Embodiments of the present invention will be described hereinafter, and these embodiments are illustrative. Of course, therefore, the embodiments can be variously modified as long as the modified embodiments do not depart from the technical conception of the present invention.

The positive photosensitive composition of the present invention is a positive photosensitive composition, which does not require heat treatment after the composition is exposed to light, and comprises the following components (A) to (C) as essential components:
(A) an alkali-soluble high molecular substance having in the molecule thereof at least one carboxyl group;
(B) a photo-thermal conversion material which absorbs infrared rays from an image exposure light source to convert the rays to heat; and
(C) a silane coupling agent.

As the aforementioned high molecular substance (A), any high molecular substance may be used without any particular limitation insofar as it has at least one carboxyl group in its molecule. Preferable examples of the high molecular substance include a polymer of an unsaturated compound (a1) having at least one carboxyl group and/or at least one carboxylic acid anhydride group and a copolymer of the unsaturated compound (a1) and a compound (a2) copolymerizable with the unsaturated compound. The high molecular substance (A) contains the carboxyl group so as to have an acid value of preferably 30 to 500 and more preferably 180 to 250. The weight average molecular weight of the high molecular substance (A) is preferably 1,500 to 100,000 and more preferably about 3,000 to 10,000.

As the aforementioned unsaturated compound (a1), maleic acid, (meth)acrylic acid, fumaric acid and itaconic acid, and their derivatives are preferable. These compounds may be used either singly or in combinations of two or more.

Preferable examples of the aforementioned maleic acid and its derivative (referred to as a maleic acid monomer) include maleic acid, maleic anhydride, maleic monoester (e.g., monomethyl maleate, monoethyl maleate, mono-n-propyl maleate, mono-isopropyl maleate, mono-n-butyl maleate, mono-isobutyl maleate and mono-tert-butyl maleate) and maleic diester.

Preferable examples of the aforementioned (meth)acrylic acid and its derivative (referred to as a (meth)acryl monomer) include (meth)acrylic acid and (meth)acrylic ester (e.g., methyl (meth)acrylate, ethyl (meth)acrylate, butyl (meth)acrylate and hydroxyethyl (meth)acrylate).

As the compound (a2) copolymerizable with the unsaturated compound (a1), compounds having an unsaturated double bond are preferable and styrene and its derivatives (referred to as styrene monomer) such as styrene, α-methylstyrene, m- or *p*-methoxystyrene, *p*-methylstyrene, *p*-hydroxystyrene, 3-hydroxymethyl-4-hydroxy-styrene are particularly preferable. These compounds may be used either singly or in combinations of two or more.

As the aforementioned high molecular substance (A), a polymer of the aforementioned maleic acid monomer, a copolymer of the maleic acid monomer used as major components, a polymer of the aforementioned (meth)acryl monomer, a copolymer of the (meth)acryl monomer used as major components, a copolymer of the maleic acid monomer, the (meth)acryl monomer and other monomer such as the styrene monomer, a styrene/maleic acid copolymer (hereinafter referred to as a copolymer (b1)) obtained by copolymerizing the maleic acid monomer with the styrene monomer, a copolymer of the (meth)acryl monomer and the styrene monomer, derivatives of these polymers or modifications of these polymers are preferable, maleic acid polymer, (meth)acrylic acid polymer, a copolymer having a structure represented by the following general formula (3) and/or the general formula (4) and a structure represented by the following general formula (5) or a copolymer of (meth)acrylic acid, (meth)acrylic acid ester and the styrene monomer are more preferable and copolymers represented by the following general formula (1) are further more preferable.

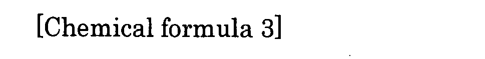

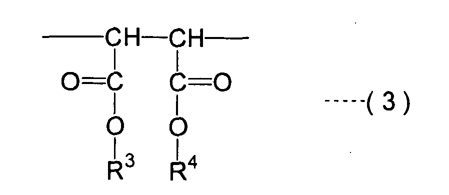

In the formula (3), "R³" and "R⁴" each independently represent a hydrogen atom or a monovalent substituent, preferably a hydrogen atom, a lower alkyl group or a group having a reactive double bond.

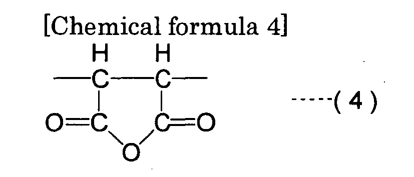

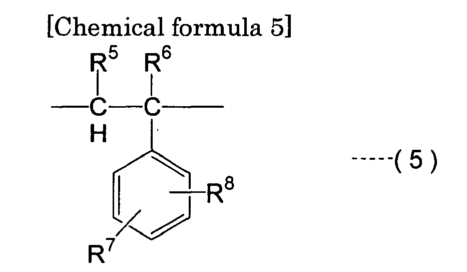

In the formula (5), "R⁵" and "R⁶" each independently represent a hydrogen atom or a monovalent substituent, preferably a hydrogen atom or a methyl group. "R⁷" represents a hydrogen atom or a monovalent substituent, preferably a hydrogen atom, or a hydroxyl group, an alkyl group or an alkoxy group, "R⁸" represents a hydrogen atom or a monovalent substituent, preferably a hydrogen atom or a hydroxyalkyl group.

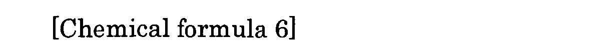

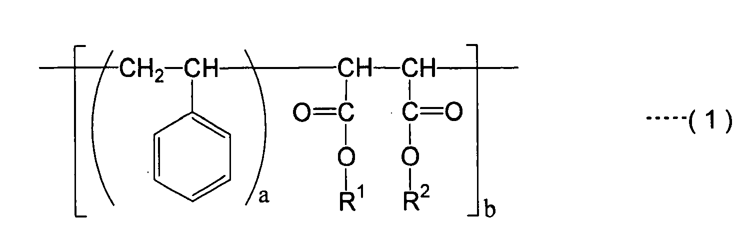

In the formula (1), "R¹" and "R²" are each independently a hydrogen atom or a monovalent substituent, preferably a hydrogen atom or a substituted or unsubstituted alkyl group, more preferably a hydrogen atom or a lower alkyl group or an alkoxyalkyl group. When a plurality of "R¹" and "R²" are present, they may be the same or different. At least one of "R¹" and "R²" is preferably a hydrogen atom, "a" is 0 or an integer of 1 or more, preferably from 1 to 3, and "b" is an integer of 1 or more, preferably from 6 to 8.

The method for producing the high molecular substance (A) is not particularly limited, and may be performed in accordance with a known method. It is preferable to react a high molecular substance having a carboxylic acid anhydride group with a compound having a hydroxyl group, thereby producing an alkali-soluble high molecular substance having a carboxyl group. For example, the above-mentioned styrene/maleic acid copolymer is preferably obtained by reacting a compound having a hydroxyl group with a styrene/maleic anhydride copolymer (that is, a copolymer of the styrene monomer and maleic anhydride) and thus esterifying the styrene/maleic anhydride copolymer.

Examples of the compound having a hydroxyl group include, though not particularly limited to, alcohols such as isopropanol, n-propanol, isopropanol/cyclohexanol, butyl alcohol, isooctanol and ethylene glycol, ethylene glycol ethers such as ethylene glycol butyl ether, and diethylene glycol ethers such as diethylene glycol ethyl ether.

Also, as the aforementioned high molecular substance (A), compounds (hereinafter referred to as a copolymer (b2)) obtained by modifying the aforementioned copolymer (b1) by using a compound having a reactive double bond may be used. In this case, the ratio of the structure represented by the formulae (3) and (4) to the structure represented by the formula (5) is preferably about 1. Specifically, it is possible to produce the above copolymer (b2) by reacting an acid hydride group or carboxyl group in the copolymer (b1) with the compound having a reactive double bond. In this case, it is necessary that a carboxyl group necessary to carry out alkali development be left in the copolymer.

As the compound having a reactive double bond, a compound having a carbon-carbon double bond is preferable. Preferable examples of the compound having a reactive double bond include an unsaturated alcohol (e.g., allyl alcohol, 2-butene-1-2-ol, furfuryl alcohol, oleyl alcohol, cinnamyl alcohol, 2-hydroxyethyl acrylate, hydroxyethyl methacrylate and N-methylol acryl- amide), alkyl (meth)acrylate (e.g., methyl methacrylate and *t*-butyl methacrylate), an epoxy compound having one oxirane ring and one reactive double bond (e.g., glycidyl acrylate, glycidyl methacrylate, allyl glycidyl ether, α-ethylglycidyl acrylate, crotonyl glycidyl ether and itaconic acid monoalkyl monoglycidyl ester).

As the above copolymer (b2), a compound may be used which is obtained by reacting a compound into which a reactive double bond is introduced by an unsaturated alcohol, with the above epoxy compound having one oxirane ring and one reactive double bond, to thereby increase the concentration of a reactive double bond.

No particular limitation is imposed on a method for producing the above copolymer (b1) or (b2) and the method may be carried out according to a known method (see, for example, Patent documents 4 to 6). A reactive double bond may be introduced also into the high molecular substance having a carboxyl group, other than a styrene/maleic acid polymer in the same manner as above. The imparting of a reactive double bond to the high molecular substance is preferable from the viewpoint of raising hardness and improving printing durability.

There is no particular limitation to the content of the high molecular substance (A) in the positive photosensitive composition of the present invention. However, the content is preferably 80 to 99% by weight and more preferably 90 to 95% by weight based on the total solid amount of the positive photosensitive composition. The high molecular substance (A) may be used either singly or in combinations of two or more.

As the above photo-thermal conversion material (B), any material may be used insofar as it is a compound capable of converting absorbed light into heat. Examples of the photo-thermal conversion material (B) include organic or inorganic pigments and dyes, organic coloring matter, metals, metal oxides, metal carbonates and metal borates, which have an absorption band in a part or all of the infrared region of wavelength of 700 to 1,100 nm. A preferable example of the photo-thermal conversion material (B) is a light-absorbing dye that efficiently absorbs light having the above wavelength range and does not almost absorb light in the ultraviolet region or does not substantially sensitized by the light if it absorbs the light. A Compound represented by the following formula (6) or (7) and their derivatives are preferably used.

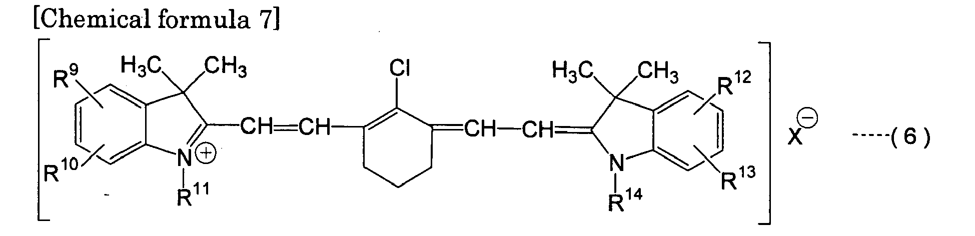

In the formula (6), "R⁹" to "R¹⁴" each independently represent a hydrogen atom, an alkyl group having 1 to 3 carbon atoms, or an alkoxy group having 1 to 3 carbon atoms, and "X⁻" represents a counter anion, and examples of "X" include halogen atoms, ClO₄, BF₄, p-CH₃C₆H₄SO₃, and PF₆.

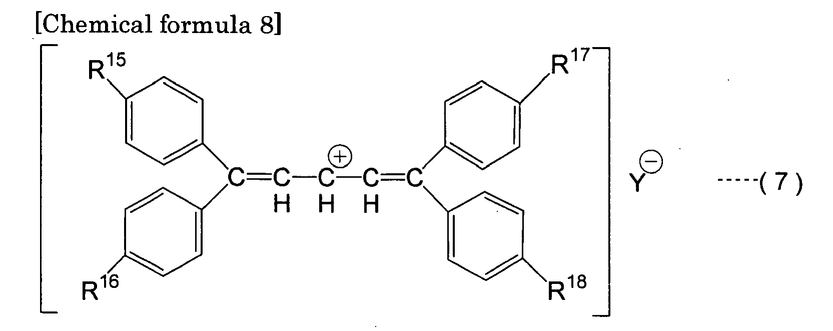

In the formula (7), "R¹⁵" to "R¹⁸" each independently represent a hydrogen atom, a methoxy group, -N(CH₃)₂, or -N(C₂H₅)₂, and "Y⁻" represents a counter anion, and examples of "Y" include C₄H₉-B(C₆H₅)₃, p-CH₃C₆H₄SO₃, and CF₃SO₃.

More preferable examples of the compound represented by the general formula (7) include near infrared absorbing colorants which are represented by the following chemical formulae (8) to (11) and have a maximum absorption wavelength in a near infrared range.

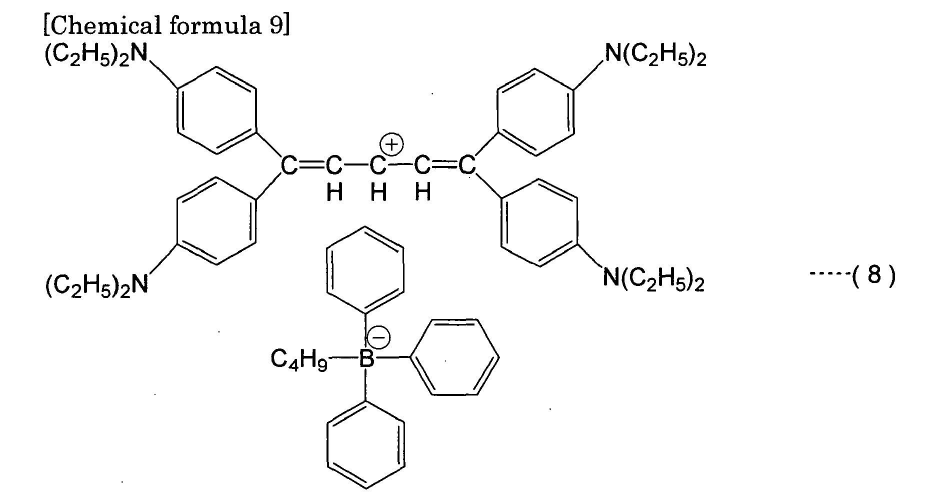

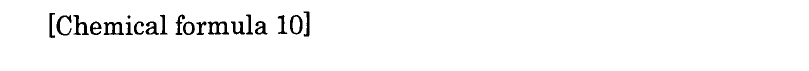

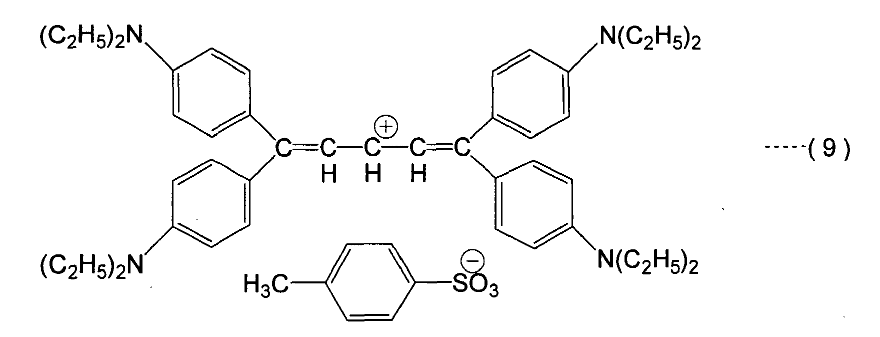

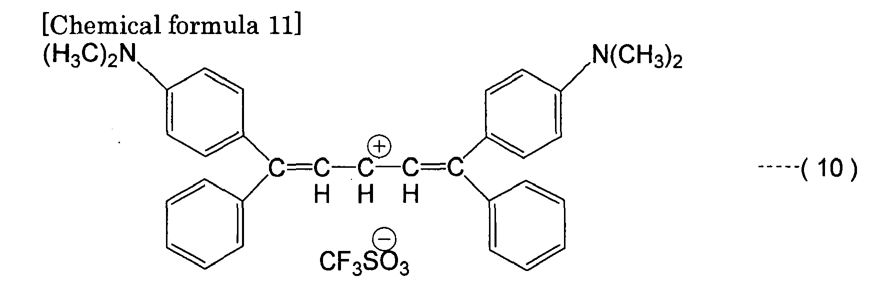

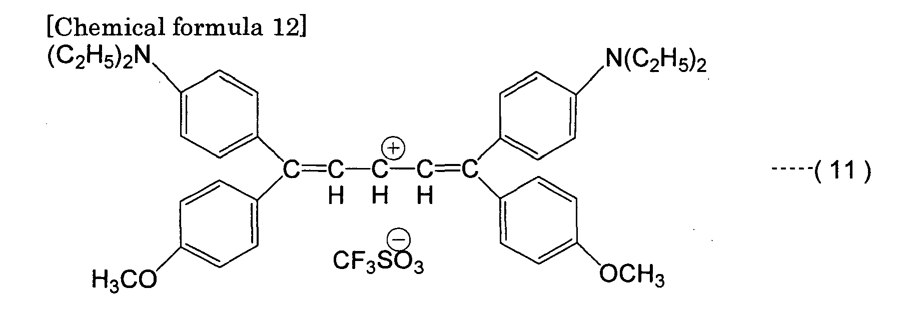

Also, examples of other light-absorbing dyes include cyanine dyes so-called in a wide sense which have the structure in which a heterocyclic ring containing a nitrogen atom, an oxygen atom or a sulfur atom are combined by a polymethine (-CH=)ₙ as described in Patent document 6. Specific examples of these cyanine dyes include a quinoline type (so-called cyanine type), indole type (so-called indocyanine type), benzothiazole type (so-called thiocyanine type), iminocyclohexadiene type (so-called polymethine type), pyrylium type, thiapyrylium type, squarylium type, croconium type and azulenium type. Among these types, a quinoline type, indole type, benzothiazole type, iminocyclohexadiene type, pyrylium type or thiapyrylium type is preferable. Particularly, phthalocyanine or cyanine is preferable.

The aforementioned photo-thermal conversion material (B) has an absorption band in a part or all of the infrared region of a wavelength of 700 to 1,100 nm, has the characteristics that it absorbs laser light of the infrared wavelength region to be heat-decomposed, and participates in molecular reduction/abrasion relative to alkali solubility which is caused by thermal cutting of a molecule of the high molecular substance (A) having a carboxyl group.

The quantity of the photo-thermal conversion material to be added relates to whether heat generated in exposure is excessive or insufficient and also, the intensity of the infrared laser relates to whether the heat decomposition of organic high molecular substance existing in the exposed portion is excessive or insufficient. Therefore, the amount of the photo-thermal conversion material is designed to be an appropriate amount. The content of the photo-thermal conversion material (B) in the positive photosensitive composition of the present invention is preferably 0.1 to 10% by weight and more preferably 1 to 4% by weight based on the total solid amount of the positive photo- sensitive composition.

The silane coupling agent (C) can be variously used from known ones, and is not particularly limited. The agent (C) is preferably a compound having an alkoxysilyl group and at least one functional group selected from the group consisting of imidazole, vinyl, epoxy, methacryloxy, acryloxy, amino, mercapto, isocyanate, styryl, and polysulfide groups.

Specific examples of the silane coupling agent (C) include imidazole silane compounds; epoxy silane compounds such as 2-(3,4 epoxycyclohexyl)ethyltrimethoxysilane, 3-glycidoxypropyltrimethoxysilane, and 3-glycidoxypropylmethyldiethoxysilane; vinylsilane compounds such as vinyltrichlorosilane, vinyltrimethoxysilane, and vinyltriethoxysilane; styrylsilane compounds such as p-styryltrimethoxysilane; methacryloxysilane compounds such as 3-methacryloxypropylmethyldimethoxysilane, 3-methacryloxypropyltrimethoxysilane, 3-methacryloxypropylmethyldiethoxysilane, and 3-methacryloxypropyltriethoxysilane; acryloxysilane compounds such as 3-acryloxypropyltrimethoxysilane; aminosilane compounds such as N-2(aminoethyl)3-aminopropylmethyldimethoxysilane, N-2(aminoethyl)3-aminopropyltrimethoxysilane, N-2(aminoethyl)3-aminopropyltriethoxysilane, 3-aminopropyltrimethoxysilane, 3-aminopropyltriethoxysilane, 3-triethoxysilyl-N-(1,3-dimethyl-butylidene)propylamine, N-phenyl-3-aminopropyltrimethoxysilane, and hydrochloride of N-(vinylbenzyl)-2-aminoethyl-3-aminopropyltrimethoxysilane; mercaptosilane compounds such as 3-mercaptopropylmethyldimethoxysilane, and 3-mercaptopropyltrimethoxysilane; isocyanate silane compounds such as 3-isocyanatopropyltriethoxysilane; bis(triethoxysilylpropyl)tetrasulfide 3-ureidopropyltriethoxysilane; and 3-chloropropyltrimethoxysilane.

Examples of the imidazole silane compounds include compounds described in Patent Document 7 and represented by the following general formulae (12) to (14) and salts thereof:

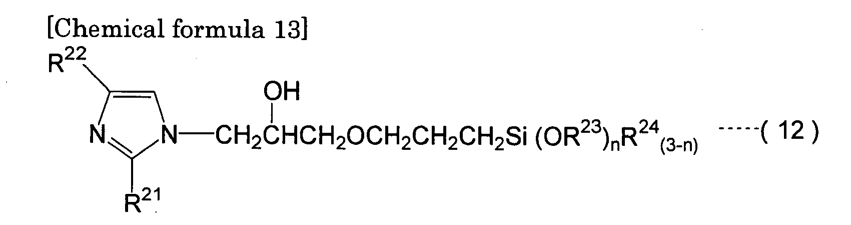

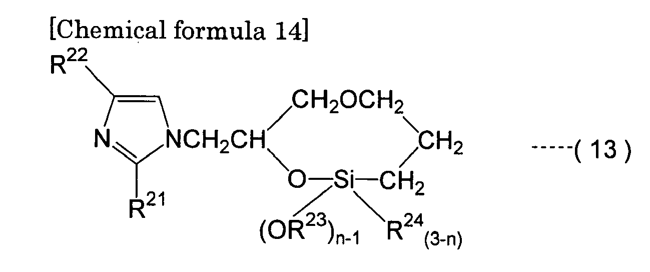

and

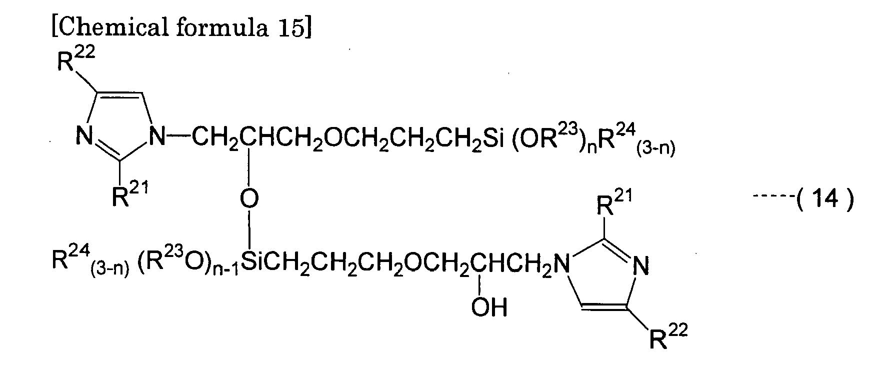

In the formulae (12) to (14), "R²¹" represents a hydrogen or an alkyl group having 1 to 20 carbon atoms, "R²²" represents a hydrogen atom, a vinyl group or an alkyl group having 1 to 5 carbon atoms, "R²³" and "R²⁴" each independently represent an alkyl group having 1 to 3 carbon atoms, and "n" is from 1 to 3.

These silane coupling agents may be used alone or in combination of two or more thereof. The content by percentage of the silane coupling agent(s) in the positive photosensitive composition of the present invention is preferably from 0.1 to 10% by weight of the total of solids in the positive photosensitive composition, more preferably from 0.2 to 5% by weight thereof.

It is preferable to incorporate a dissolution inhibitor (D) into the positive photosensitive composition of the present invention. The aforementioned dissolution inhibitor (D) is compounded for the purpose of increasing a time difference of solubility in an alkali developing solution between an exposed portion and an unexposed portion. As the dissolution inhibitor (D), a compound is used which has the ability of forming a hydrogen bond together with the high molecular substance (A) to reduce the solubility of the high molecular substance, does not almost absorb light in the infrared region and is not decomposed by light in the infrared region.

As the dissolution inhibitor (D), there is preferably used a compound represented by the following formula (2) (4,4'-[1-[4-[1-(4-hydroxyphenyl)-1-methylethyl]phenyl]ethylidene]bisphenol).

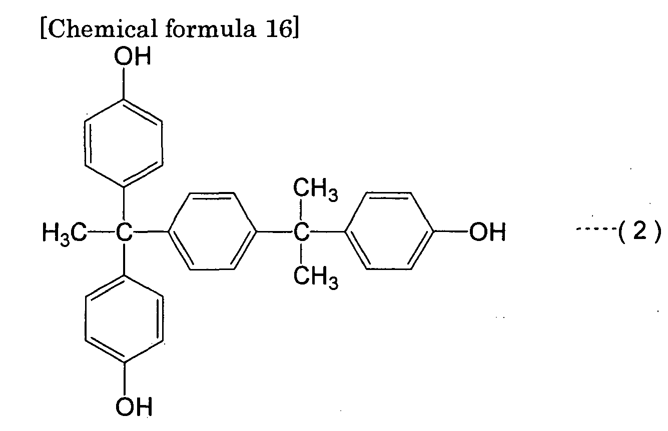

Also, known dissolution inhibitors may be used as the dissolution inhibitor (D). Specific examples of the dissolution inhibitor (D) include a sulfonic ester, phosphoric ester, aromatic carboxylic ester, aromatic disulfone, carboxyanhydride, aromatic ketone, aromatic aldehyde, aromatic amine, aromatic ether, acid color developing dyes having a lactone skeleton, thiolactone skeleton, N,N-diaryl amide skeleton or diaryl methylimino skeleton, base color developing dyes having lactone skeleton, thiolactone skeleton or sulfolactone skeleton, nonionic surfactant and so on. Among these materials, acid color developing dye having lactone skeleton is preferable.

The content of the dissolution inhibitor (D) in the positive photosensitive composition of the present invention is preferably 0.5 to 8% by weight and more preferably 1 to 5% by weight based on the total solid amount of the positive photo- sensitive composition. These dissolution inhibitors may be used either singly or in combinations of two or more.

The positive photosensitive composition of the present invention may comprise, besides the above-mentioned components, if necessary, various additives such as an adhesion-modifying agent, a photo sensitizer, coloring agents such as pigments or dyes, a development promoter, and a coating improving agent.

The adhesion-modifying agent is not particularly limited, and there may be preferably used an alkali-soluble resin such as a vinylpyrrolidone/vinyl acetate copolymer, a vinylpyrrolidone/dimethylaminoethyl methacrylate copolymer, a vinylpyrrolidone/vinylcaprolactam/dimethylaminoethyl methacrylate copolymer, polyvinyl acetate, polyvinyl butyral, polyvinyl formal, a terpene phenol resin, an alkylphenol resin, a melamine/formaldehyde resin, and a ketone resin. These adhesion-modifying agents may be used alone or in combination of two or more thereof.

The coloring agent is in particular preferably a triarylmethane dye. As the triarylmethane dye, triarylmethane dyes known in the prior art can be variously used. Specifically, there may be preferable methyl violet, crystal violet, Victoria Blue B, Oil Blue 613(a trade name of a product manufactured by Orient Chemical Industries, Ltd.), and derivatives thereof. These triarylmethane dyes can be used alone or in combination of two or more thereof.

The use of the coloring dyes produces an effect that pinholes, dust or the like on the surface of the photosensitive film can be clearly recognized at the time of forming a pattern therein by development, so that a stopping out operation with a retouching solution (opaque) is easily conducted. As the concentration of the dye is higher, the pinholes or the like are more easily recognized, which is preferred. In the semiconductor industry, retouching cannot be conducted; thus, semiconductors are produced in clean rooms. However, in the printing industry and the industry related to electronic parts, retouching is conducted to reproduce inferior goods.

As to the above-mentioned development promoter, it is preferable to add, for example, a dicarboxylic acid, an amine compound or a glycol compound in a very small amount. As the above-mentioned photo sensitizer, there is preferably a compound which generates an acid by action of light or heat. Examples of the photo sensitizer include diphenyliodonium salts, triphenylsulfonium salts, aromaticsulfonic acid esters, triazine compounds, and diazodisulfone compounds. A compound represented by the following formula (25) is particularly preferable.

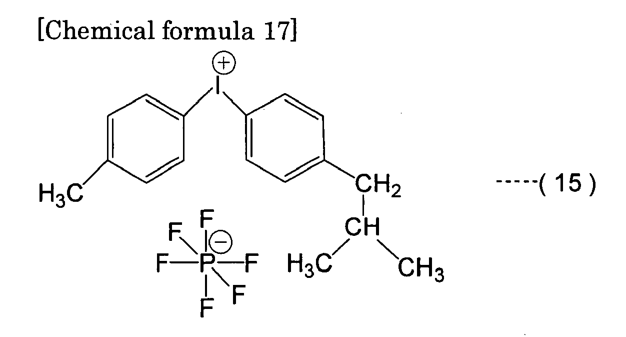

The positive photosensitive composition of the present invention is usually used in the form of a solution obtained by dissolving the composition in a solvent. The proportion by weight of the solvent to be used is generally in a range from 1 to 20 times the total solid content of the photosensitive composition.

As the solvent, any solvent may be used without any particular limitation insofar as it has enough solubility to components used and imparts good coatability, and a cellosolve type solvent, propylene glycol type solvent, ester type solvent, alcohol type solvent, ketone type solvent or highly polar solvent may be used. Examples of the cellosolve type solvent include methyl cellosolve, ethyl cellosolve, methyl cellosolve acetate and ethyl cellosolve acetate. Examples of the propylene glycol type solvent include propylene glycol monomethyl ether, propylene glycol monoethyl ether, propylene glycol monobutyl ether, propylene glycol monomethyl ether acetate, propylene glycol monoethyl ether acetate, propylene glycol monobutyl ether acetate, dipropylene glycol dimethyl ether. Examples of the ester type solvent include butyl acetate, amyl acetate, ethyl butyrate, butyl butyrate, diethyl oxalate, ethyl pyruvate, ethyl-2-hydroxybutyrate, ethyl acetoacetate, methyl lactate, ethyl lactate and methyl-3-methoxypropionate. Examples of the alcohol type solvent include heptanol, hexanol, diacetone alcohol and furfuryl alcohol. Examples of the highly polar solvent include ketone type solvents such as cyclohexanone and methyl amyl ketone, dimethylformamide, dimethylacetamide and N-methyl-pyrrolidone. Examples other than the above include acetic acid, mixtures of these solvents, and, further, solvents obtained by adding an aromatic hydrocarbon to these solvents.

The positive photosensitive composition of the present invention may be produced in the following manner. Usually, the above each component is dissolved in a solvent such as a cellosolve type solvent or propylene glycol type solvent to make a solution, which is then applied to the surface of the support, specifically, the copper or copper sulfate plating surface of the plate- making roll for gravure printing use and naturally dried. Then, the roll is rotated at high speed so that the surface of the plate-making roll goes through the air. A mass effect due to centrifugal force in the photosensitive film and the condition of the neighborhood of the surface placed under a slightly negative pressure allow the concentration of residual solvents to be reduced to 6% or less, to thereby make a positive photosensitive film with the photo- sensitive composition layer being formed on the surface of the support.

As a coating method, meniscus coating, fountain coating, dip coating, rotary coating, roll coating, wire bar coating, air-knife coating, blade coating and curtain coating may be used. The thickness of the coating film is in a range preferably from 1 to 6 µm and more preferably 3 to 5 µm.

As the light source used for image exposure of the positive photosensitive composition layer, a semiconductor laser and a YAG laser which emit infrared laser rays having a wavelength of 700 to 1,100 nm are preferable. Besides the above, a solid laser such as a ruby laser and LED may be used. The intensity of the laser light source is designed to be 50 to 700 mJ/scm² and particularly preferably 80 to 250 mJ/scm².

As a developing solution used for the photosensitive film formed by using the positive photosensitive composition of the present invention, a developing solution comprising an inorganic alkali (e.g., salts of Na or K) or an organic alkali (e.g., TMAH (Tetra Methyl Ammonium Hydroxide) or choline) is preferable.

The development is carried out at usually about 15 to 45°C and preferably 22 to 32°C by dipping development, spray development, brush development, ultrasonic development and so on.

### Examples:

The present invention will be more specifically described by way of working examples hereinafter. Of course, however, these examples are illustrative, and should not be interpreted to be restrictive.

### (Examples 1 to 4)

The ingredients and proportions shown in Table 1 were used to prepare positive photosensitive compositions. These were used as test photosensitive solutions.

**[Table 1]**

| Ingredients | | | Example 1 | Example 2 | Example 3 | Example 4 | Experiment example 1 | Experiment example 2 |
|---|---|---|---|---|---|---|---|---|
| Component (A) | Resin 1 | | 100 | 100 | 100 | - | 100 | - |
| | Resin 2 | | - | - | - | 100 | - | - |
| | Novolak resin | | - | - | - | - | - | 100 |
| Component (B) | IR-photosensitive dye | | 3 | 2 | 5 | 1 | 3 | 3 |
| Component (C) | Silane coupling agent 1 | | 1 | - | - | 1 | - | - |
| | Silane coupling agent 2 | | - | 1 | - | - | - | - |
| | Silane coupling agent 3 | | - | - | 1 | - | - | 1 |
| | Dissolution inhibitor | | 2 | 2 | 2 | 2 | - | - |
| | Color dye | | 2 | 2 | 2 | 2 | 2 | 2 |
| | Solvent | PM | 590 | 590 | 590 | 590 | 590 | 590 |
| | | IPA | 737 | 737 | 737 | 737 | 737 | 737 |
| | | MEK | 589 | 589 | 589 | 589 | 589 | 589 |

The components in Table 1 are as follows and proportions of each blending materials are shown in parts by weight:
Resin 1: SMA 2624 (a partial ester of a styrene/maleic anhydride copolymer with n-propanol, manufactured by SARTOMER Company, Inc.)
Resin 2: Oxylack SH-101 (styrene/semi-ester of maleic acid copolymer, manufactured by Nippon Shokubai Kagaku Kogyo Co., Ltd.; acid value: 180, melting point: 190°C, and molecular weight: 8000-9000)
Novolak resin: PR-NMD-100 (manufactured by Sumitomo Bakelite Co., Ltd.)
IR-photosensitive dye: IR-B (infrared absorbing dye represented by the formula (8), manufactured by Showa Denko K.K.)
Silane coupling agent 1: KBE-403 (3-glycidoxypropyltriethoxysilane, manufactured by Shin-Etsu Chemical Co., Ltd.)
Silane coupling agent 2: KBE-503 (3-methacryloxypropyltriethoxysilane, manufactured by Shin-Etsu Chemical Co., Ltd.)
Silane coupling agent 3: IM-100F (imidazole silane compound, manufactured by NIPPON MINING & METALS Co., Ltd.)
Dissolution inhibitor: Tris P·PA (compound represented by the formula (2), manufactured by HONSYU CHEMICAL INDUSTRY Co., Ltd.)
Color dye: Oil Blue 613 (Color Index (C.I.) No. 42595, manufactured by Orient Chemical Industries, Ltd.)
PM: propylene glycol monomethyl ether
IPA: isopropyl alcohol
MEK: methyl ethyl ketone

The following experiments were made using the obtained test sensitizing solutions. The experiment was carried out under the condition that laboratory was maintained at a temperature of 25°C and the humidity shown in Table 2. A plate-making roll of φ 200 mm which used iron as base material of the roll and was plated with copper sulfate and mirror-polished was rotated at 25 r.p.m. with the both ends thereof being chucked by a fountain coating apparatus (apparatus equipped with a dehumidifier and a humidifier where the humidity can be controlled desirably) and thoroughly wiped and cleaned by a wiping cloth. It is to be noted that the fountain coating apparatus has the ability to avoid the phenomenon that solvents in the positive photosensitive composition are vaporized to change the ratio of these solvents during coating.

Thereafter, a pipe allowing the test sensitizing solution to be overflowed from the top thereof was positioned at one end of the plate-making roll so as to form a gap of about 500 µm from the roll. The pipe was moved from one end to the other end of the roll with making the test sensitizing solution overflow in an amount necessary for coating, to apply the test sensitizing solution uniformly to the roll by a spiral scan method, and the rotation was continued at 25 r.p.m. for 5 minutes after the application was finished and then stopped.

Five minutes were taken for waiting until oozing of a liquid was observed, with the result that the generation of the oozing of a liquid could not be observed with the naked eye. Then, the film thickness was measured, to find that there was no difference in thickness between the lower surface part and upper surface part of the roll. It was thus confirmed that the photosensitive film dried to a solid condition permitting no oozing of a liquid was set.

In succession, the test roll was rotated at 100 r.p.m. for 20 minutes and then stopped to measure the concentration of residual solvents in the photosensitive film, to find that the concentration was 2.9%. After the photosensitive solution was coated, the resultant was heated at 70°C for 10 minutes.

Then, the test roll was fit to an exposure apparatus (manufactured by Think Laboratory Co., Ltd.) mounted with a high-power semiconductor laser head of CreoScitex Co., Ltd. and then irradiated with laser light having a wavelength falling in the infrared region to print a positive image. Next, the test roll was fit to a developing machine and was developed with rotating the roll and lifting the developing tank until no residue was observed, followed by washing with water. As the developing solution, 4.2% KOH (25°C) was used. The resulting resist image was evaluated by a microscope. The results are shown in Table 2.

**[Table 2]**

| | Etching depth (µm) | Etching factor | Sensitivity (mJ/cm²) | Development time (seconds) | Image | Image after plating | Rate of residual film (%) |
|---|---|---|---|---|---|---|---|
| Example 1 | 80 | 1.78 | 220 | 75 | ⊚ | ⊚ | 75 |
| Example 2 | 80 | 1.79 | 220 | 75 | ⊚ | ⊚ | 76 |
| Example 3 | 80 | 1.81 | 220 | 75 | ⊚ | ⊚ | 75 |
| Example 4 | 80 | 1.80 | 220 | 75 | ⊚ | ⊚ | 75 |
| Experiment Example 1 | 80 | 1.66 | 220 | 75 | ○ | ⊚ | 74 |
| Experiment Example 2 | 80 | 1.67 | 250 | 75 | Δ | Δ | 70 |

The methods of evaluation in Table 2 are as follows:
1) Etching depth and etching factor
   A Cellzoh (a depth/area/bank-width automatically measuring apparatus manufactured by Dai Nippon Printing Co., Ltd. and sold by Think Laboratory Co., Ltd.) was used to measure the etching depth and the side etching amount. The etching factor was then calculated therefrom.
2) Sensitivity
   Exposure amount was varied to find one at which an image pattern was reproduced most exactly to decide the sensitivity. As the exposure apparatus, a thermal imaging head manufactured by Creo Co., Ltd. was used.
3) Developing time
   The developing time taken until no residue was found was measured.
4) Image
   The reproducibility of an original image was evaluated.
5) Image after plating
   The state of the plated surface was observed. The good state where the surface is glossy and good in smoothness and has uniformity in thickness and the bottom of the cell is not rough was evaluated as ⊚, and any state other than the good state was evaluated as Δ.
6) The rate of residual film
   Film thickness before and after development were measured using FILMETRICS Thin Film Analyzer F20 (manufactured by Filmetrics Co.) which calculates thickness of coating film to calculate the rate of residual film.

As shown in Table 2, the positive photosensitive compositions of Examples 1 to 4 made it possible to carry out good development to obtain a sharp pattern freed of residues in about 70 seconds. Furthermore, the adhesion was good, the etching factor was improved at the etching depth of 80 µm, and the side etching was restrained.

The experiment was also made in the case of using a copper surface or an aluminum surface in place of the copper sulfate plated surface. In all of these cases, the satisfactory results as in Example 1 were obtained.

### (Experimental examples 1 and 2)

As to Experimental example 1, the same experiment as in Example 1 were made except that the proportions of the ingredients were changed as shown in Table 1. As to Experimental example 2, the same experiments as in Example 1 were made except that the proportions of the ingredients were changed as shown in Table 1 and a 2% by weight aqueous solution of KOH was used as a developing solution. The results are shown in Table 2. As shown in Table 2, these ingredients each were lower in adhesion and poorer in etching factor than those in Examples 1 to 4.

### Capability of Exploitation in Industry:

The positive photosensitive composition of the present invention is preferably used to form a positive photosensitive film on the copper sulfate surface of a plate-making roll for gravure printing. However, no particular limitation to the material on which the composition of the present invention is applied. Even if the composition is applied to plates of metals such as aluminum, zinc and steel, metal plates on which aluminum, zinc, copper, iron, chromium, nickel, or the like is plated or deposited, paper coated with a resin, paper coated with a metal foil such as an aluminum foil, plastic films, hydrophilically treated plastic films, glass plates, and so on, it has high adhesion at low temperatures, ensuring that high sensitivity is obtained.

The positive photosensitive composition of the present invention is, therefore, preferably used for photosensitive planographic printing plates, proofs for simplified proofing printing, wiring boards, gravure copper etching resists, color-filter resists used to produce flat displays, photoresists for producing LSI, a member related for forgery prevention and the like.

## Claims

1. A positive photosensitive composition, which is excellent in an etching factor, comprising:
(A) an alkali-soluble high molecular substance having in the molecule thereof at least one carboxyl group;
(B) a photo-thermal conversion material which absorbs infrared rays from an image exposure light source to convert the rays to heat, and
(C) a silane coupling agent.

2. The positive photosensitive composition according to claim 1, wherein the silane coupling agent (C) is a silane coupling agent having an alkoxysilyl group and at least one functional group selected from the group consisting of imidazole, vinyl, epoxy, methacryloxy, acryloxy, amino, mercapto, isocyanate, styryl, and polysulfide groups.

3. A photo-fabrication process, comprising the use of the positive photosensitive composition according to claim 1 or 2.

4. The photo-fabrication process according to claim 3, which is applied to a printing plate, an electronic component, a precision equipment component, or a component relating to counterfeit deterrence.

5. A plate-making method, comprising the use of the positive photosensitive composition according to claim 1 or 2.
